Europäisches Patentamt

(19) European Patent Office    (11) Publication number: **0 230 953**

Office européen des brevets    **A2**

## (12) EUROPEAN PATENT APPLICATION

(21) Application number: **87100658.1**    (51) Int. Cl.⁴: **H 01 L 21/56**
**H 01 L 21/318**

(22) Date of filing: **20.01.87**

(30) Priority: **20.01.86 JP 9089/86**

(71) Applicant: **Kabushiki Kaisha Toshiba**
**72, Horikawa-cho Saiwai-ku**
**Kawasaki-shi Kanagawa-ken 210  (JP)**

(43) Date of publication of application:
**05.08.87  Bulletin  87/32**

(72) Inventor: **Tezaki, Atsumu**
**A203, Kopo Yayoi 2040, Nakanoshima**
**Tama-ku Kawasaki-shi Kanagawa-ken  (JP)**

(84) Designated Contracting States: **DE FR GB**

**Aoki, Riichirou**
**2-9-2, Ichikawa**
**Ichikawa-shi Chiba-ken  (JP)**

**Okumura, Katsuya**
**609, Rupinasu 1.4.6, Utsukushigaoka**
**Midori-ku Yokohama-Shi Kanagawa-ken  (JP)**

(74) Representative: **Lehn, Werner, Dipl.-Ing. et al**
**Hoffmann, Eitle & Partner Patentanwälte Arabellastrasse**
**4**
**D-8000 München 81  (DE)**

The title of the invention has been amended (Guidelines for Examination in the EPO, A-III, 7.3).

(54) **Process for manufacturing a semiconductor device having a protective layer.**

(57) After forming an interconnecting layer (2) on a semiconductor substrate (1), a protective layer (3; 3, 4) of silicon nitride is formed. At least a part (3) of the protective layer (3; 3, 4) is formed by bias sputtering method so that it does not contain hydrogen. The protective layer (3; 3, 4) formed by the process does not affect electronic characteristics of the device, and it is able to completely prevent invasions of impurities from outside and prevent crackings caused by heat stress.

F I G. 3

EP 0 230 953 A2

**Description**

PROCESS FOR MANUFACTURING A SEMICONDUCTOR DEVICE

BACKGROUND OF THE INVENTION

This invention relates to a process for manufacturing a semiconductor device and, more particularly, to a process for manufacturing a semiconductor device having a silicon nitride layer as an outer protective layer.

A semiconductor device generally comprises active devices such as MOS transistors, interconnecting layers such as aluminium layers for electrically interconnecting the active devices and protective layers such as phosphosilicate glass layers (hereinafter referred to as PSG layers) formed in the interconnecting layers. The protective layers protect the active devices against invasion of impurities from outside and ensure the operation reliability in the devices. The typical impurities affecting the operation of the devices are water and movable ions such as sodium ions. Water causes erosion of the metal interconnecting layers, and movable ions unexpectedly change electrical characteristics in the device through migration in semiconductor layers. Unfortunately, both water and sodium ions are common materials in this art.

A PSG layer is one of the most common protective layers for protecting the semiconductor devices from the invasion of impurities from outside. However, there is a problem that the PSG layer cannot avoid both the invasion of water and sodium ions completely. A protective ability of the PSG layer depends on phosphorous content in the layer. Increase in the phosphorous content improves the protective effect against sodium invasion, but it reduces the protective effect against water invasion because phosphorus has water absorption characteristics. Therefore, it is difficult to improve the protective ability of the PSG layer against the invasions of both water and sodium ions. The PSG layer has another problem as a protective layer, that is, it is relatively brittle and easy to break, and, especially, it tends to crack due to heat stress based on the difference in the heat expansion coefficients between a PSG layer and an adjacent layer.

The most commonly used protective layer next to a PSG layer is a silicon nitride layer. It is well known that the silicon nitride layer has a good protective ability against both water and sodium ions. The silicon nitride layer is usually formed by a plasma CVD (Chemical Vapor Deposition) method using the following chemical reaction.

$$3SiH_4 + 4NH_3 \rightarrow Si_3N_4 + 12H_2$$

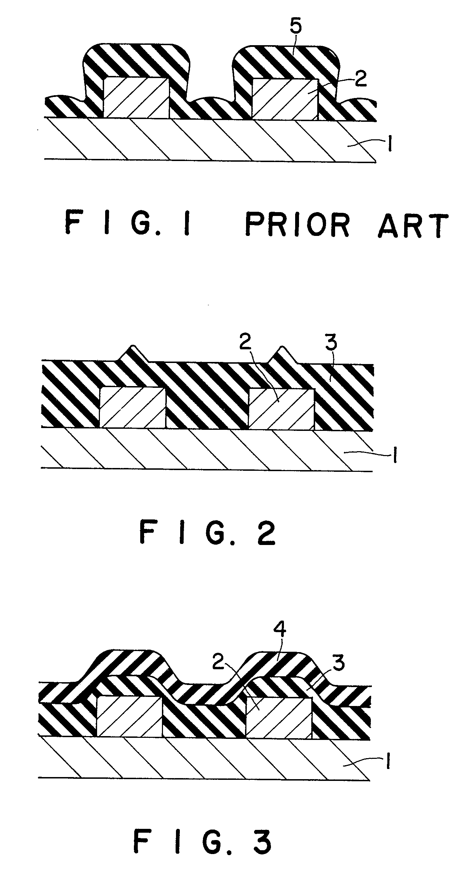

Fig. 1 shows a cross-sectional view of a semiconductor device having a silicon nitride layer formed by the above described method. On a semiconductor substrate 1, interconnecting layers 2 made of an aluminium alloy are formed and thereon a silicon nitride layer 5 is formed by a plasma CVP method. However, the silicon nitride layer 5 formed by the plasma CVD method contains hydrogen as explained in the above described chemical reaction. Usually the hydrogen content becomes 20 to 50 percents of the total atoms in the layer. The hydrogen atoms in the layer induce a hot electron effect and unexpectedly change a threshold value of MOS transistors. Thus the hydrogen in the layer causes a serious problem that affects the reliability of semiconductor devices.

Another problem of a silicon nitride layer resides in its brittleness. Similar to a PSG layer, a silicon nitride layer tends to crack due to heat stress caused by the difference in the heat expansion coefficients between a silicon nitride layer and an adjacent layer.

SUMMARY OF THE INVENTION

The object of this invention is to provide an inproved process for manufacturing a semiconductor device capable of forming a protective layer which can completely avoid invasion of impurities from outside without affecting the electrical characteristics of the device, and avoiding forming cracks caused by heat stress.

The above described object is accomplished by providing a process comprising the steps of preparing a semiconductor substrate, forming an interconnecting layer on the substrate and forming a protective layer of silicon nitride on the substrate and the interconnecting layer, at least a part of the protective layer being formed by bias sputtering method.

BRIEF DESCRIPTION OF THE DRAWINGS

In the accompanying drawings:

Fig. 1 is a cross-sectional view showing a semiconductor device having a silicon nitride layer formed by a process according to a prior art;

Fig. 2 is a cross-sectional view showing a semiconductor device having a silicon nitride layer formed by a process according to the present invention; and

Fig. 3 is a cross-sectional view showing a modified semiconductor device having two silicon nitride layers formed by a process according to the present invention.

DETAILED DESCRIPTION OF THE PREFERRED EMBODIMENT

Referring to Figs. 2 and 3, a preferred embodiment of this invention will be described in detail. Fig. 2 shows a cross-sectional view of a semiconductor device manufactured by a process of the first embodiment of this invention. In the process, interconnecting layers 2 made of aluminium alloy are formed on a semiconductor substrate 1, then a silicon nitride layer 3 is formed on these layers 2 and substrate 1. The characterizing feature of the process lies that the silicon nitride layer 3 is formed by bias sputtering method instead of plasma CVD method of the prior art. As has been described in connection with Fig. 1, the silicon nitride layer 5 in the prior art is formed by the plasma CVD method. In the bias sputtering method, a bias voltage is supplied to the silicon substrate 1 and a spatter is carried out using a silicon nitride target and a mixture of sputtering gases or argon and nitrogen. Due to the characteristics of the bias sputtering method, the formed silicon nitride layer 3 has a relatively flat surface, though its under layer has a rugged surface.

Fig. 3 shows a cross-sectional view of a semiconductor device manufactured by a process of the second embodiment of this invention. In this device, a silicon nitride layer comprises two layers, that is, a silicon nitride layer 3 formed by a bias sputtering method and a silicon nitride layer 4 formed by normal sputtering method. In the first stage of the process, silicon nitride is deposited by the bias sputtering method on the surfaces of the silicon substrate 1 and interconnecting layers 2 until the thickness of the formed layer 3 reaches a predetermined value. Then, in the second stage of the process, silicon nitride is deposited by the normal sputtering method on the surface of the layer 3 until the thickness of the formed layer 4 reaches a predetermined value. Since the bias sputtering method is used in the first stage, the resulting silicon nitride layers 3 and 4 have a flatter surface than a layer formed by using plasma CVD method or by merely using normal sputtering method.

A silicon nitride layer formed by the above described process (hereinafter called a layer of this invention) has the following advantages over a layer formed by processes according to prior arts (hereinafter called a prior layer).

The first advantage is that the layer of this invention is able to completely prevent invasion of impurities from outside. As mentioned before, a silicon nitride layer has higher protective ability than a PSG layer.

The second advantage is that the layer of this invention is able to ensure predetermined electronic characteristics in a semiconductor device, because it does not contain hydrogen, which affects electrical characteristics of the device, differing from a prior art layer formed by plasma CVD method.

The third advantage of the layer of this invention is that the tendency of forming cracks is lower than that of a prior art layer.

The above described advantages are experimentally demonstrated in the following tables, wherein the column "PSG layer" indicates experimental data in specimens of semiconductor devices having a PSG layer according to the prior art; the column "P-SiN layer", having a silicon nitride layer formed by plasma CVD method according to prior art; the column "embodiment 1", having a silicon nitride layer formed by the process of the first embodiment of the invention; and the column "embodiment 2", having a silicon nitride layer formed by the process of the second embodiment of the invention, respectively.

(1) Water-tightness test

Specimens of semiconductor devices were subjected to pressure of 2.5 atms and maintained in air having a humidity of 100% for predetermined test times described in Table 1 shown below. After the test times have elapsed, the aluminium interconnecting layers of the specimens were tested for conductivity faults. The test results are shown in Table 1 in percentage. It was confirmed in the test that the specimens manufactured by the processes of the embodiments 1 and 2 show good water-tightness as in the case of the specimen having a P-SiN layer.

## Table 1

| Test time | PSG layer | P-SiN layer | Embodiment 1 | Embodiment 2 |
|---|---|---|---|---|
| 500 hours | 35% | 0% | 0% | 0% |
| 1000 hours | 100% | 0% | 0% | 0% |

(2) Threshold Value Test

Specimens of semiconductor devices having n-channel MOS FET's were tested for threshold value differences of the FET's. The first threshold value was measured for the devices before protective layers were formed and the second threshold value was measured for the devices after the protective layers were formed. The test results are shown in Table 2, wherein the differences between the first threshold value and the second threshold value are shown in volts. It was confirmed in the test that the specimens manufactured by the process of the embodiments 1 and 2 have no threshold value differences. Therefore it was found that the process according to the invention ensures better electronic characteristics.

## Table 2

| | PSG layer | P-SiN layer | Embodiment 1 | Embodiment 2 |
|---|---|---|---|---|
| threshold difference (volt) | -0.1 | -0.5 | 0.0 | 0.0 |

(3) Cracking Test

Specimens of semiconductor devices comprised an aluminium interconnecting layer with a width of 20, 40, 80 and 100 μm described in Table 3 shown below and a thickness of 0,8 μm covered by a protective layer with a width of 1.2 μm. In the test, the specimens were subjected to a temperature cycle of heating to 150° C and then cooling to -55° C, and a thousand of temperature cycles were applied to the specimens. After applying the temperature cycles, cracks formed in the specimens were observed by a photo-microscope. The test results are shown in Table 3. It was confirmed in the test that the process according to the invention can prevent cracking.

## Table 3

| Interconnecting layer width | PSG layer | P-SiN layer | Embodiment 1 | Embodiment 2 |
|---|---|---|---|---|
| 20 μm | no crack | no crack | no crack | no crack |
| 40 μm | some cracks | no crack | no crack | no crack |
| 80 μm | many cracks | no crack | no crack | no crack |
| 100 μm | many cracks | a few cracks | no crack | a few cracks |

## Claims

1. A process for manufacturing a semiconductor device which comprises steps of preparing a semiconductor substrate (1), forming an interconnecting layer (2) on the substrate (1) and forming a protective layer (3; 3, 4) of silicon nitride on the substrate (1) and the interconnecting layer (2), characterized in that at least a part (3) of said protective layer (3; 3, 4) is formed by bias sputtering method.

2. A process as defined in claim 1 wherein the protective layer (3; 4) is formed as an outermost layer of the device.

3. A process as defined in claim 1 or 2 wherein the bias sputtering method is carried out with a target of silicon nitride and with a sputtering gas mixture of argon and nitrogen.

4

FIG. 1 PRIOR ART

FIG. 2

FIG. 3